# EUROPEAN PATENT APPLICATION

(11) **EP 4 576 974 A1**
(43) Date of publication of application: **25.06.2025**
(21) Application number: 24193057.7
(22) Date of filing: 06.08.2024
(51) Int. Cl.: H10B 12/00

(54) **SEMICONDUCTOR DEVICE**

(30) Priority: 20.12.2023 KR 20230187519
(71) Applicant: SAMSUNG ELECTRONICS CO., LTD., Yeongtong-gu Suwon-si, Gyeonggi-do 16677 (KR)
(72) Inventor: OH, Seran, 16677 Suwon-si, Gyeonggi-do (KR); KANG, Yunho, 16677 Suwon-si, Gyeonggi-do (KR); KIM, Minsik, 16677 Suwon-si, Gyeonggi-do (KR); KIM, Yeonuk, 16677 Suwon-si, Gyeonggi-do (KR); LEE, Byounghoon, 16677 Suwon-si, Gyeonggi-do (KR); LEE, Jangeun, 16677 Suwon-si, Gyeonggi-do (KR)
(74) Representative: Kuhnen & Wacker Patent- und Rechtsanwaltsbüro PartG mbB

(57) **Abstract**

Provided is a semiconductor device (100) and method of manufacturing same. The semiconductor device (100) includes: a substrate (110) including a first active area (AC1) defined by a first device separation film (112); a bit line contact (DC) in the first active area (AC1); and a bit line (BL) extending in a first direction on the substrate (110), wherein the bit line (BL) includes: a lower conductive layer (132) on the substrate (110) and surrounding at least a portion of a sidewall of the bit line contact (DC); a metal silicide film (134) on the lower conductive layer (132) and the bit line contact (DC); an intermediate layer (137); and a conductive layer (138) that are sequentially arranged on the metal silicide film (132) in a vertical direction (Z) perpendicular to the substrate (110), and wherein the intermediate layer (137) includes a tantalum (Ta) alloy.

## Description

### BACKGROUND

### 1. Field

The disclosure relates to a semiconductor device, and more particularly, to a semiconductor device including a bit line.

### 2. Description of Related Art

As semiconductor devices are downscaled, the size of separate microcircuit patterns for implementing semiconductor devices is further reduced. As integrated circuit devices become more highly integrated, the line width of bit lines decreases and the spacing between bit lines also decreases. Therefore, defects may occur in a process of forming bit lines with a reduced line width.

### SUMMARY

Provided is a semiconductor device with improved reliability.

According to an aspect of the disclosure, a semiconductor device includes: a substrate including a first active area defined by a first device separation film; a bit line contact in the first active area; and a bit line extending in a first direction on the substrate, wherein the bit line includes: a lower conductive layer on the substrate and surrounding at least a portion of a sidewall of the bit line contact; a metal silicide film on the lower conductive layer and the bit line contact; and an adhesive layer (or intermediate layer) and a conductive layer that are sequentially arranged on the metal silicide film in a vertical direction perpendicular to the substrate, and wherein the adhesive layer includes a tantalum (Ta) alloy.

According to an aspect of the disclosure, a semiconductor device includes: a substrate including a first active area and a second active area; a bit line contact in the first active area; a peripheral circuit gate stack in the second active area; and a bit line extending in a first direction on the substrate, wherein the bit line includes a lower conductive layer on the substrate and surrounding at least a portion of a sidewall of the bit line contact, and a metal line stack on the lower conductive layer, and wherein the metal line stack includes a barrier metal layer, an adhesive layer (or intermediate layer)on the barrier metal layer, and a conductive layer on the adhesive layer.

According to an aspect of the disclosure, a semiconductor device includes: a substrate including an active area defined by a device separation film; a bit line contact in a bit line contact hole extending into the substrate, wherein the bit line contact is connected to the active area; a bit line extending in a first direction on the substrate and including: a lower conductive layer on the substrate, surrounding at least a portion of a sidewall of the bit line contact, a metal silicide film on the lower conductive layer, and a metal line stack on the metal silicide film; a bit line spacer on a sidewall of the bit line and extending in the first direction; and a word line in a word line trench extending in a second direction intersecting with the first direction, wherein the word line intersects with the active area, wherein the metal line stack includes a barrier metal layer, an adhesive layer (or intermediate layer), and a conductive layer that are sequentially arranged in a direction perpendicular to the substrate, and wherein the adhesive layer includes tantalum boron (TaB) and the conductive layer includes ruthenium (Ru).

The disclosure is not limited to the technical objects described above and other objects that are not stated herein will be clearly understood by those skilled in the art from the following specifications.

### BRIEF DESCRIPTION OF DRAWINGS

The above and other aspects, features, and advantages of certain embodiments of the present disclosure will be more apparent from the following description taken in conjunction with the accompanying drawings, in which:
FIG. 1 is a layout diagram showing a semiconductor device according to one or more embodiments;
FIG. 2 is an enlarged layout diagram of a region P of FIG. 1;
FIG. 3 is a cross-sectional view taken along a line A-A' of FIG. 2;
FIG. 4 is a cross-sectional view taken along a line B-B' of FIG. 2;
FIG. 5 is a cross-sectional view taken along a line C-C' of FIG. 2;
FIGS. 6A and 6B are cross-sectional views showing a semiconductor device according to one or more embodiments;
FIGS. 7A and 7B are cross-sectional views showing a semiconductor device according to one or more embodiments;
FIGS. 8A and 8B are cross-sectional views showing a semiconductor device according to one or more embodiments;
FIGS. 9A and 9B are cross-sectional views showing a semiconductor device according to one or more embodiments;
FIGS. 10A and 10B are cross-sectional views showing a semiconductor device according to one or more embodiments; and
FIGS. 11A, 11B, 12A, 12B, 13A, 13B, 14A, 14B, 15A, 15B, 16A, 16B, 17A, 17B, 18A, 18B, 19A, 19B, 20A, and 20B are cross-sectional views showing a method of manufacturing a semiconductor device, according to one or more embodiments.

### DETAILED DESCRIPTION

Hereinafter, embodiments will be described in detail with reference to the attached drawings. In the drawings, the same components are denoted by the same reference numerals, and a repeated explanation thereof will not be given.

As the disclosure allows for various changes and numerous embodiments, particular embodiments will be illustrated in the drawings and described in detail in the written description. However, this is not intended to limit the disclosure to particular modes of practice, and it is to be appreciated that all changes, equivalents, and substitutes that do not depart from the spirit and technical scope of the disclosure are encompassed in the disclosure. In the description of embodiments, certain detailed explanations of related art are omitted when it is deemed that they may unnecessarily obscure the essence of the disclosure.

As used herein, a plurality of "units", "modules", "members", and "blocks" may be implemented as a single component, or a single "unit", "module", "member", and "block" may include a plurality of components.

It will be understood that when an element is referred to as being "connected" with or to another element, it can be directly or indirectly connected to the other element.

Also, when a part "includes" or "comprises" an element, unless there is a particular description contrary thereto, the part may further include other elements, not excluding the other elements.

Throughout the description, when a member is "on" another member, this includes not only when the member is in contact with the other member, but also when there is another member between the two members.

Herein, the expressions "at least one of a, b or c" and "at least one of a, b and c" indicate "only a," "only b," "only c," "both a and b," "both a and c," "both b and c," and "all of a, b, and c."

It will be understood that, although the terms "first", "second", "third", etc., may be used herein to describe various elements, is the disclosure should not be limited by these terms. These terms are only used to distinguish one element from another element.

As used herein, the singular forms "a," "an" and "the" are intended to include the plural forms as well, unless the context clearly indicates otherwise.

With regard to any method or process described herein, an identification code may be used for the convenience of the description but is not intended to illustrate the order of each step or operation. Each step or operation may be implemented in an order different from the illustrated order unless the context clearly indicates otherwise. One or more steps or operations may be omitted unless the context of the disclosure clearly indicates otherwise.

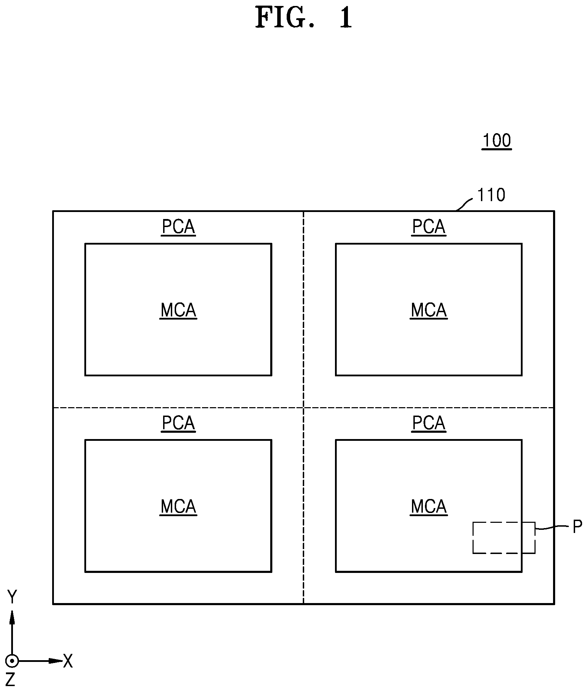

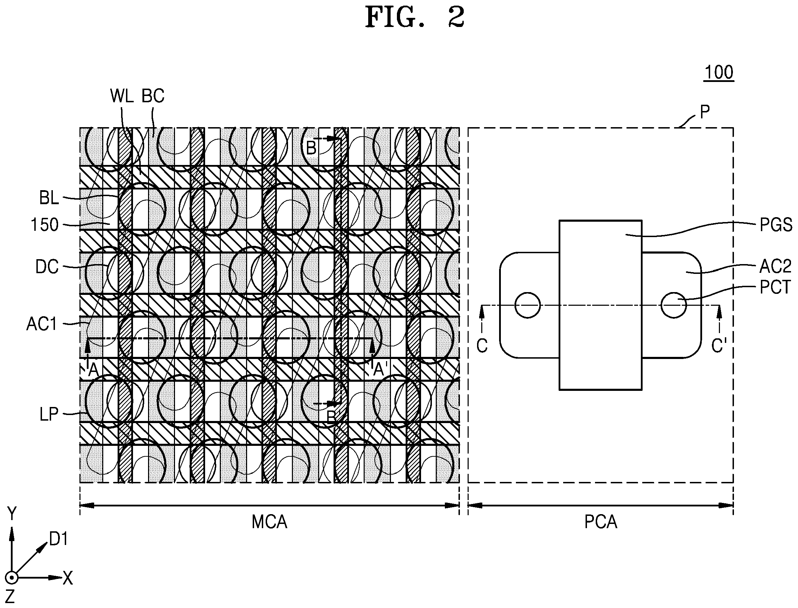

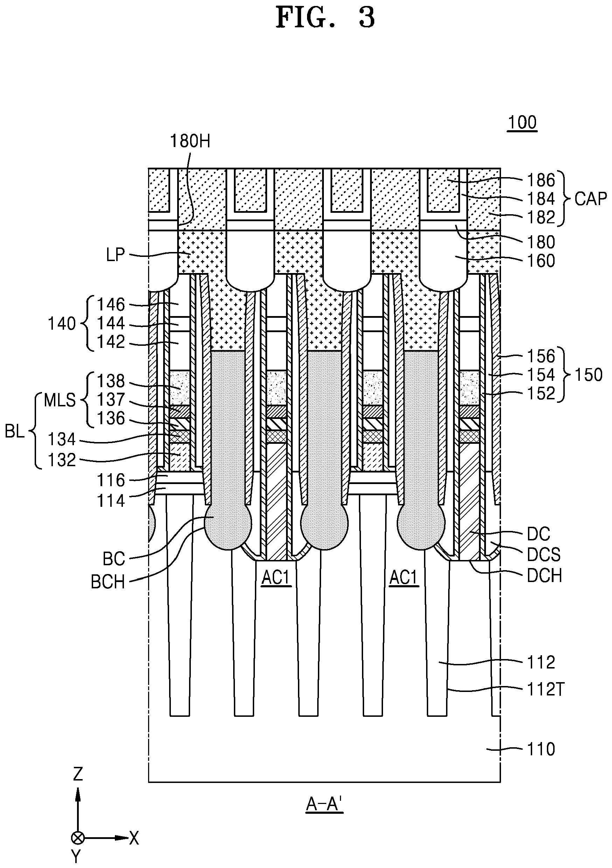

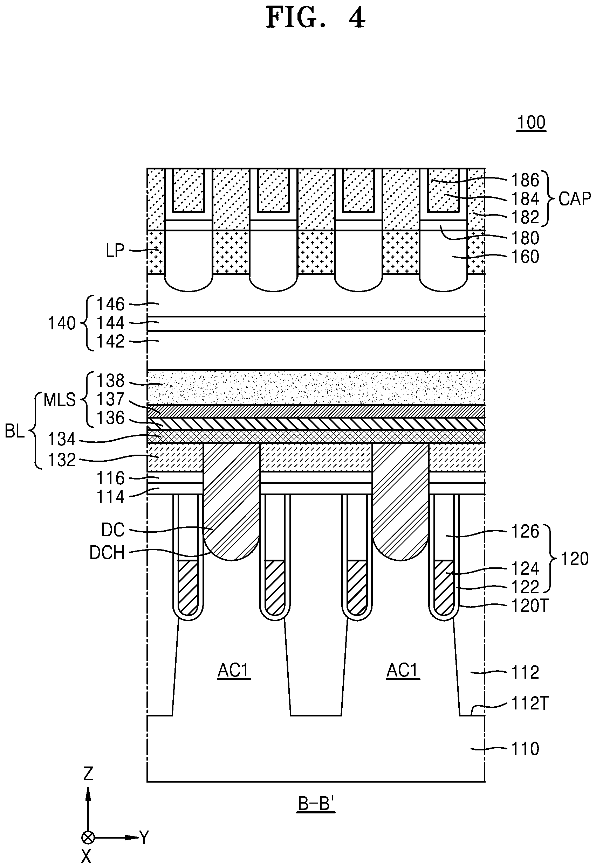

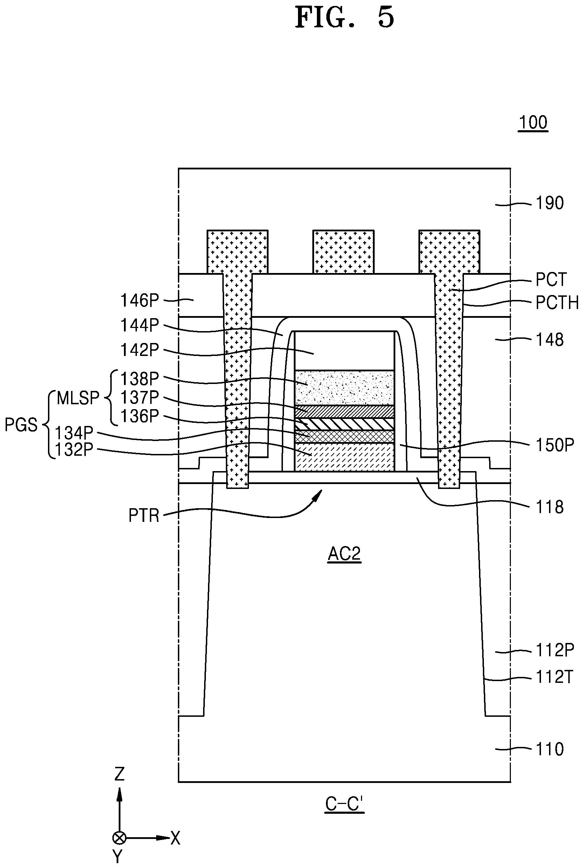

FIG. 1 is a layout diagram showing a semiconductor device according to one or more embodiments. FIG. 2 is an enlarged layout diagram of a region P of FIG. 1. FIG. 3 is a cross-sectional view taken along a line A-A' of FIG. 2. FIG. 4 is a cross-sectional view taken along a line B-B' of FIG. 2. FIG. 5 is a cross-sectional view taken along a line C-C' of FIG. 2.

Referring to FIGS. 1 through 5, a semiconductor device 100 may include a substrate 110 including a cell array area MCA and a peripheral circuit area PCA. The cell array area MCA may be a memory cell area of a dynamic random access memory (DRAM) device, and the peripheral circuit area PCA may be a core area or a peripheral circuit area of the DRAM device. For example, the cell array area MCA may include a cell transistor and a capacitor structure CAP connected thereto, and the peripheral circuit area PCA may include a peripheral circuit transistor PTR for transmitting a signal and/or power to the cell transistor included in the cell array area MCA. In one or more embodiments, the peripheral circuit transistor PTR may constitute various circuits such as a command decoder, a control logic, an address buffer, a row decoder, a column decoder, a sense amplifier, and a data input/output circuit.

A device separation trench 112T may be formed in the substrate 110, and a first device separation film 112 and a second device separation film 112P may be formed in the device separation trench 112T. A plurality of first active areas AC1 may be defined in the cell array area MCA of the substrate 110 by the first device separation film 112, and a plurality of second active areas AC2 may be defied in the peripheral circuit area PCA by the second device separation film 112P.

As shown in FIG. 2, within the cell array area MCA, the plurality of first active areas AC1 may be arranged to each have a long axis in a first diagonal direction (D1 direction) inclined with respect to a first horizontal direction (X direction) and a second horizontal direction (Y direction). A plurality of word lines WL may extend parallel to each other in the first horizontal direction (X direction) across the plurality of first active areas AC1. A plurality of bit lines BL may extend parallel to each other in the second horizontal direction (Y direction) on the plurality of word lines WL. The plurality of bit lines BL may be connected to the plurality of first active areas AC1 through a bit line contact DC.

A plurality of buried contacts BC may be formed between two adjacent bit lines BL from among the plurality of bit lines BL. A plurality of landing pads LP may be formed on the plurality of buried contacts BC. The plurality of buried contacts BC and the plurality of landing pads LP may connect a lower electrode 182 of the capacitor structure CAP formed on the plurality of bit lines BL to a first active area AC 1. The plurality of landing pads LP may be arranged to partially overlap the buried contact BC and the bit line BL.

The substrate 110 may include silicon, for example, single crystalline silicon, polycrystalline silicon, or amorphous silicon. In some other embodiments, the substrate 110 may include at least one selected from Ge, SiGe, SiC, GaAs, InAs, and InP. In one or more embodiments, the substrate 110 may include a conductive area, for example, a well doped with an impurity, or a structure doped with an impurity.

The first device separation film 112 may include an oxide film, a nitride film, or a combination thereof. A first buffer insulating layer 114 and a second buffer insulating layer 116 may be sequentially disposed on an upper surface of the substrate 110. Each of the first buffer insulating layer 114 and the second buffer insulating layer 116 may include silicon oxide, silicon oxynitride, or silicon nitride.

A plurality of word line trenches 120T extending in the first horizontal direction (X direction) may be disposed in the substrate 110, and a buried gate structure 120 may be located within the plurality of word line trenches 120T. The buried gate structure 120 may include a gate dielectric layer 122, a gate electrode 124, and a word line capping layer 126 that are located within each of the plurality of word line trenches 120T. The plurality of gate electrodes 124 may correspond to the plurality of word lines WL illustrated in FIG. 2.

The plurality of gate dielectric layers 122 may include a silicon oxide film, a silicon nitride film, a silicon oxynitride film, an oxide/nitride/oxide (ONO) film, or a high-k dielectric film having a higher dielectric constant than the silicon oxide film. The plurality of gate electrodes 124 may include Ti, TiN, Ta, TaN, W, WN, TiSiN, WSiN, or a combination thereof. The plurality of word line capping layers 126 may include a silicon oxide film, a silicon nitride film, a silicon oxynitride film, or a combination thereof.

A plurality of bit line contact holes DCH may extend into the substrate 110 to pass through the first buffer insulating layer 114 and the second buffer insulating layer 116, and the plurality of bit line contacts DC may be formed in a plurality of bit line contact holes DCH. The plurality of bit line contacts DC may be connected to the plurality of first active areas AC1. The plurality of bit line contacts DC may include doped polysilicon. The bit line contact spacer DCS may cover a lower side of the bit line contact DC inside a bit line contact hole DCH.

The plurality of bit lines BL may extend a long way in the second horizontal direction (Y direction) on the substrate 110 and the plurality of bit line contacts DC. The plurality of bit lines BL may each be connected to the first active area AC1 through the bit line contact DC.

Each of the plurality of bit lines BL may include a lower conductive layer 132, a metal silicide film 134, and a metal line stack MLS.

The lower conductive layer 132 may extend in the second horizontal direction (Y direction) on the second buffer insulating layer 116, and the lower conductive layer 132 may cover both sidewalls of the bit line contact DC. For example, as shown in FIG. 4, an upper surface of the lower conductive layer 132 may be located on the same plane as an upper surface of the bit line contact DC, and both sidewalls of the bit line contact DC may be in contact with the lower conductive layer 132. The lower conductive layer 132 may include Si, Ge, W, WN, Co, Ni, Al, Mo, Ru, Ti, TiN, Ta, TaN, Cu, or a combination thereof.

In one or more embodiments, in a process for forming the bit line contact hole DCH, a portion of the lower conductive layer 132, a portion of the second buffer insulating layer 116, a portion of the first buffer insulating layer 114, and a portion of the substrate 110 may be removed, and the bit line contact DC may be formed in the bit line contact hole DCH. Accordingly, an upper side of the bit line contact DC may be in contact with the lower conductive layer 132, and a lower side of the bit line contact DC may be in contact with the substrate 110 (e.g., the first active area AC1).

The metal silicide film 134 may be disposed on an upper surface of the lower conductive layer 132 and an upper surface of the bit line contact DC and extend in the second horizontal direction (Y direction). In one or more embodiments, the lower conductive layer 132 may include polysilicon, and the metal silicide film 134 may include at least one of cobalt silicide, nickel silicide, and tungsten silicide. In one or more embodiments, the metal silicide film 134 may be deposited to a thickness of about 1.0 nm to about 3.0 nm.

A metal line stack MLS may include a barrier metal layer 136, an adhesive layer 137, and a conductive layer 138 that are sequentially disposed on the metal silicide film 134. The adhesive layer 137 may also be referred to as an intermediate layer. For example, the metal line stack MLS may have a structure in which the adhesive layer 137 is sandwiched between the barrier metal layer 136 and the conductive layer 138.

In one or more embodiments, the sum of the thickness of the barrier metal layer 136 and the thickness of the adhesive layer 137 may range from about 1.0 nm to about 5.0 nm. In one or more embodiments, the thickness of the adhesive layer 137 may not exceed 20% of the thickness of the conductive layer 138. In one or more embodiments, the barrier metal layer 136 may include any one of TiN, TaN, WN, TiSiN, or an alloy thereof. In one or more embodiments, the adhesive layer 137 may include any one of TEOS, SiN, TiN, TaB, Ta, TaN, or an alloy thereof. In one or more embodiments, the adhesive layer 137 may include TaB. In this case, the content of B in the composition of TaB included in the adhesive layer 137 may not exceed 30%.

In one or more embodiments, the conductive layer 138 may include ruthenium (Ru). In one or more embodiments, the conductive layer 138 may have a single composition including any one material selected from Rh, Ir, Mo, Cu, Co, and W and include an alloy material that is any one of RuAl, NiAl, NbB₂, MoB₂, MoW, or an alloy thereof.

The semiconductor device 100 according to the disclosure may suppress agglomeration of a material included in the conductive layer 138 by locating the adhesive layer 137 below the conductive layer 138.

For example, in the case of the bit line BL including a single layer of a metal material such as Ru, when the bit line BL has a reduced line width, grain agglomeration or grain merging may occur in the metal material such as Ru included in the bit line BL during a subsequent process at high temperature. The bit line BL shown in the disclosure may be formed as a line pattern extending in the second horizontal direction (Y direction), but after a high temperature subsequent process, a line width of a portion of the bit line BL may be locally increased due to grain agglomeration, and accordingly, a line width of another portion of the bit line BL may locally decrease, or a region in which the bit line BL is discontinuously disconnected may be formed.

However, according to one or more embodiments, the adhesive layer 137 may be located between the barrier metal layer 136 and the conductive layer 138 and may function as an anti-grain agglomeration layer that suppresses grain agglomeration or grain merging of a material included in the conductive layer 138, and even if the bit line BL has a reduced line width (or a relatively small line width), grain agglomeration of the metal material included in the conductive layer 138 may be prevented.

A plurality of bit line capping layers 140 may be disposed on each of the plurality of bit lines BL. Each of the bit line capping layers 140 may include a first capping layer 142, a second capping layer 144, and a third capping layer 146 that are sequentially disposed on an upper surface of each of the plurality of bit lines BL. The first capping layer 142, the second capping layer 144, and the third capping layer 146 may include at least one of silicon nitride, silicon oxide, and silicon oxynitride.

Bit line spacers 150 may be located on both sidewalls of each bit line BL. The bit line spacer 150 may include a first spacer layer 152, a second spacer layer 154, and a third spacer layer 156. In one or more embodiments, the first spacer layer 152 and the third spacer layer 156 may each include silicon nitride, and the second spacer layer 154 may each include silicon oxide. The first spacer layer 152, the second spacer layer 154, and the third spacer layer 156 may be sequentially located on each of a sidewall of the bit line BL and a sidewall of the bit line capping layer 140.

For example, as the bit line spacer 150 is located on the sidewall of the bit line BL, the first spacer layer 152 of the bit line spacer 150 may be in contact with the metal line stack MLS of the bit line BL. For example, the first spacer layer 152 may extend in a vertical direction (Z direction) along sidewalls of the barrier metal layer 136, the adhesive layer 137, and the conductive layer 138 of the metal line stack MLS on the sidewalls of the barrier metal layer 136, the adhesive layer 137, and the conductive layer 138 of the metal line stack MLS.

The plurality of buried contacts BC may be located between the plurality of bit lines BL. For example, bottom portions of the plurality of buried contacts BC may be located in a buried contact hole BCH extending into the substrate 110 between two adjacent bit lines BL, and the bottom portion of the buried contact BC may be in contact with the first active area AC1. In one or more embodiments, the plurality of buried contacts BC may include doped polysilicon.

A plurality of insulating fences may be located between two adjacent bit lines BL in the second horizontal direction (Y direction). The plurality of insulating fences may be located at positions that perpendicularly overlap the plurality of word line trenches 120T. From a plan view, the plurality of buried contacts BC and the plurality of insulating fences may be alternately arranged between the two bit lines BL extending in the second horizontal direction (Y direction).

The plurality of landing pads LP may be disposed on the plurality of buried contacts BC. Each of the plurality of landing pads LP may include a conductive barrier film and a landing pad conductive layer. The conductive barrier film may include Ti, TiN, or a combination thereof. The landing pad conductive layer may include metal, metal nitride, conductive polysilicon, or a combination thereof. For example, the landing pad conductive layer may include W. The plurality of landing pads LP may have a plurality of island type pattern shapes when viewed from a plan view.

The plurality of landing pads LP may be electrically insulated from each other by an insulating pattern 160 surrounding the plurality of landing pads LP. The insulating pattern 160 may include at least one of silicon nitride, silicon oxide, and silicon oxynitride.

An etch stop film 180 may be disposed on the insulating pattern 160, and the etch stop film 180 may have an opening 180H. The opening 180H may be located at a position corresponding to the landing pad LP, and an upper surface of the landing pad LP may be located at the bottom of the opening 180H.

The capacitor structure CAP may be disposed on the etch stop film 180. The capacitor structure CAP may include the lower electrode 182, a capacitor dielectric layer 184, and an upper electrode 186. A bottom portion of the lower electrode 182 may be located within the opening 180H of the etch stop film 180 and placed on the landing pad LP. The capacitor dielectric layer 184 may be located to be thin to conformally cover the lower electrode 182, and the upper electrode 186 may be disposed on the capacitor dielectric layer 184.

The peripheral circuit transistor PTR (FIG. 5) may be disposed in the second active area AC2 of the peripheral circuit area PCA. The peripheral circuit transistor PTR may include a gate dielectric layer 118, a peripheral circuit gate stack PGS, and a gate capping pattern 142P that are sequentially stacked on the second active area AC2.

The gate dielectric layer 118 may be disposed on the upper surface of substrate 110. The gate dielectric layer 118 may include at least one selected from a silicon oxide film, a silicon nitride film, a silicon oxynitride film, an oxide/nitride/oxide (ONO), or a high-k dielectric film having a higher dielectric constant than the silicon oxide film. The gate capping pattern 142P may be located to cover the upper surface of the peripheral circuit gate stack PGS. In one or more embodiments, the gate capping pattern 142P may include a silicon nitride film.

The peripheral circuit gate stack PGS may include a peripheral lower conductive layer 132P, a peripheral metal silicide layer 134P, and a peripheral metal line stack MLSP.

The peripheral lower conductive layer 132P may be located on the gate dielectric layer 118 and may include Si, Ge, W, WN, Co, Ni, Al, Mo, Ru, Ti, TiN, Ta, TaN, Cu, or a combination thereof. The peripheral metal silicide layer 134P may be located on the upper surface of the peripheral lower conductive layer 132P. In one or more embodiments, the peripheral metal silicide layer 134P may include at least one of cobalt silicide, nickel silicide, and tungsten silicide. In one or more embodiments, at least one conductive barrier layer of titanium, titanium nitride, or tantalum nitride may optionally be further disposed on the peripheral metal silicide layer 134P.

The peripheral metal line stack MLSP may include a peripheral barrier metal layer 136P, a peripheral adhesive layer 137P, and a peripheral conductive layer 138P that are sequentially disposed on the peripheral metal silicide layer 134P. For example, the peripheral metal line stack MLSP may have a structure in which the peripheral adhesive layer 137P is sandwiched between the peripheral barrier metal layer 136P and the peripheral conductive layer 138P.

In one or more embodiments, the sum of the thickness of the peripheral barrier metal layer 136P and the thickness of the peripheral adhesive layer 137P may range from about 1.0 nm to about 3.0 nm. In one or more embodiments, the thickness of the peripheral adhesive layer 137P may not exceed 20% of the thickness of the peripheral conductive layer 138P. In one or more embodiments, the barrier metal layer 136 may include any one of TiN, TaN, WN, TiSiN, or an alloy thereof. In one or more embodiments, the peripheral adhesive layer 137P may include any one of TEOS, SiN, TiN, TaB, Ta, TaN, or an alloy thereof. In one or more embodiments, the peripheral adhesive layer 137P may include TaB. In this case, the content of B in the composition of TaB included in the peripheral adhesive layer 137P may not exceed 30%.

In one or more embodiments, the peripheral conductive layer 138P may include ruthenium (Ru). In one or more embodiments, the peripheral conductive layer 138P may have a single composition including any one material selected from Rh, Ir, Mo, Cu, Co, and W and include an alloy material that is any one of RuAl, NiAl, NbB₂, MoB₂, MoW, or an alloy thereof.

In one or more embodiments, materials of the peripheral lower conductive layer 132P, the peripheral metal silicide layer 134P, the peripheral barrier metal layer 136P, the peripheral adhesive layer 137P, and the peripheral conductive layer 138P are respectively the same as materials of the lower conductive layer 132, the metal silicide film 134, the barrier metal layer 136, the adhesive layer 137, and the conductive layer 138 included in the bit line BL of the cell array area MCA. For example, the peripheral circuit gate stack PGS may be formed simultaneously in a process of forming the bit line BL. However, the disclosure is not limited thereto.

Both sidewalls of the peripheral circuit gate stack PGS and the gate capping pattern 142P may be covered by an insulating spacer 150P. The insulating spacer 150P may include an oxide film, a nitride film, or a combination thereof. The peripheral circuit transistor PTR and the insulating spacer 150P may be covered by a protective layer 144P, and a first interlayer insulating film 148 may be disposed on the protective layer 144P to fill a space between two adjacent peripheral circuit transistors PTR. A capping insulating layer 146P may be disposed on the first interlayer insulating film 148 and the protective layer 144P.

A contact plug PCT may be formed in a contact hole PCTH formed to pass through the first interlayer insulating film 148 and the capping insulating layer 146P in the peripheral circuit area PCA. The contact plug PCT may include a conductive barrier film and a landing pad conductive layer, similarly to the plurality of landing pads LP formed in the cell array area MCA. A metal silicide film may be located between the second active area AC2 and the contact plug PCT. An upper interlayer insulating film 190 covering the contact plug PCT may be disposed on the capping insulating layer 146P.

In general, resistance of the bit lines BL increases as a line width of the plurality of bit lines BL decreases, and thus a technology of employing a metal material with low resistivity, for example, a metal material such as Ru, as the bit line BL has been attempted. However, when a metal material such as Ru is patterned to have a relatively small line width, grain agglomeration or grain merging occurs in a subsequent high-temperature process, and thus the roughness of a metal material layer significantly increases, a line width locally increases in a certain region, a line width decreases in a certain region, and/or line disconnection occurs in a certain region.

However, according to embodiments, in the metal line stack MLS, the adhesive layer 137 may be further disposed on the barrier metal layer 136, and a Ta alloy included in the adhesive layer 137 may prevent grain agglomeration of a metal material included in the conductive layer 138. Accordingly, the bit line BL has a low resistance while preventing a region with a locally increased line width, a region with a reduced line width, and/or a region with a disconnected line from being generated within the bit line BL during a process of forming the semiconductor device 100. Therefore, the semiconductor device 100 may have excellent electrical characteristics.

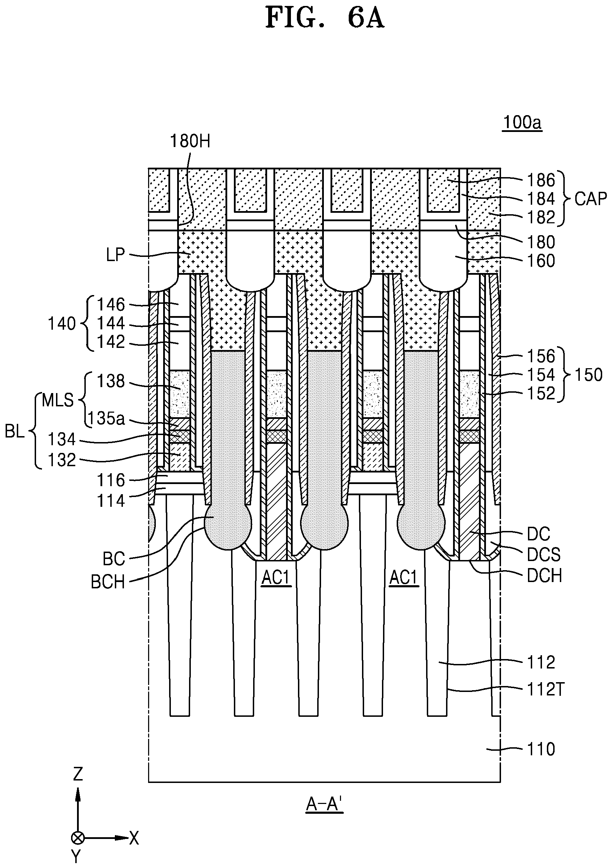

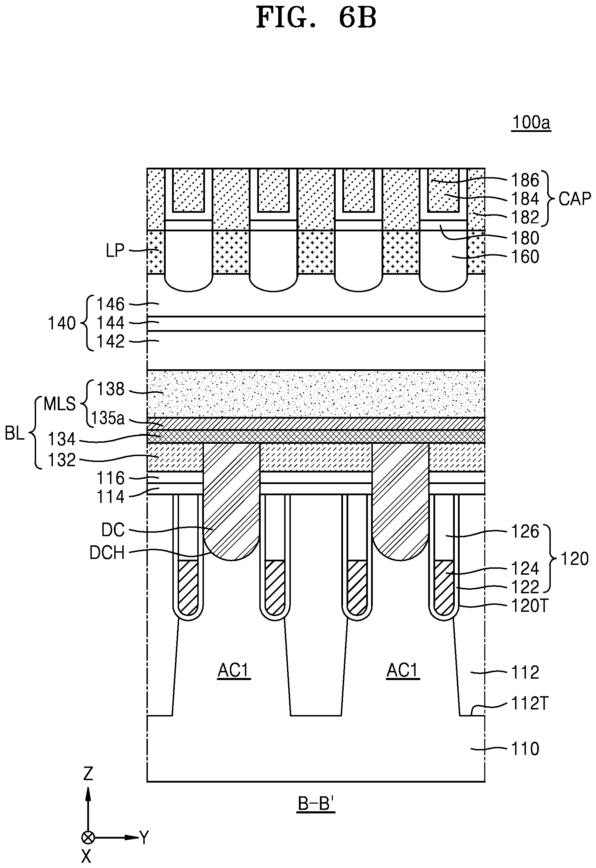

FIGS. 6A and 6B are cross-sectional views showing a semiconductor device 100a according to one or more embodiments. It will be understood that the semiconductor device 100a of FIGS. 6A and 6B is not mutually exclusive with the semiconductor device 100 described with reference to FIGS. 1 to 5, and components having the same reference numerals may be considered to be the same component. Hereinafter, repeated descriptions of similar components will be omitted, and differences from the semiconductor device 100 of FIGS. 1 to 5 will be mainly described.

Referring to FIGS. 6A and 6B, the metal line stack MLS may include a first intermediate layer 135a and the conductive layer 138, and the thickness of the first intermediate layer 135a in the vertical direction (Z direction) may range from about 1.0 nm to about 5.0 nm. In one or more embodiments, the first intermediate layer 135a may include TaB. In this case, the content of B in the composition of TaB included in the first intermediate layer 135a may not exceed 30%. Compared to the semiconductor device 100 of FIGS. 1 to 5, the first intermediate layer 135a included in the semiconductor device 100a of FIGS. 6A to 6B may replace the barrier metal layer 136 and the adhesive layer 137 of the semiconductor device 100 of FIGS. 1 to 5.

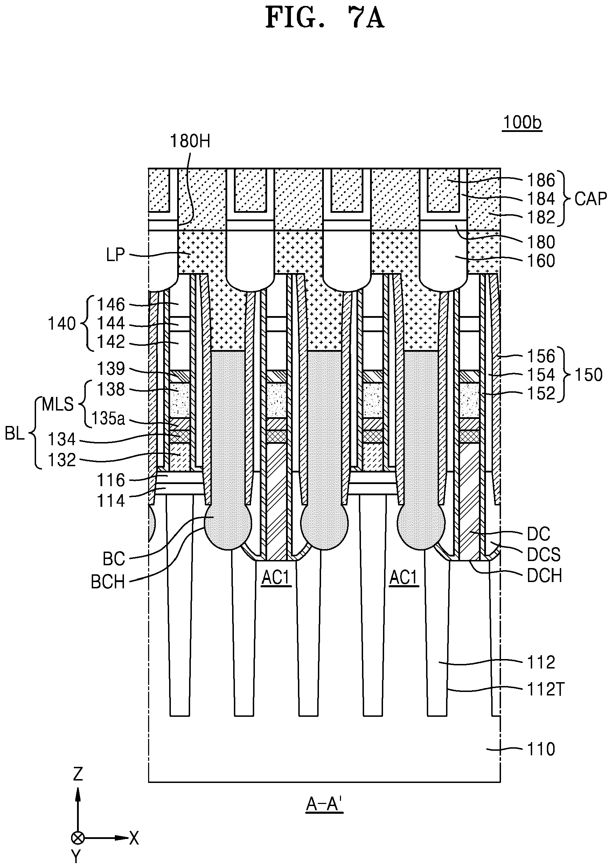

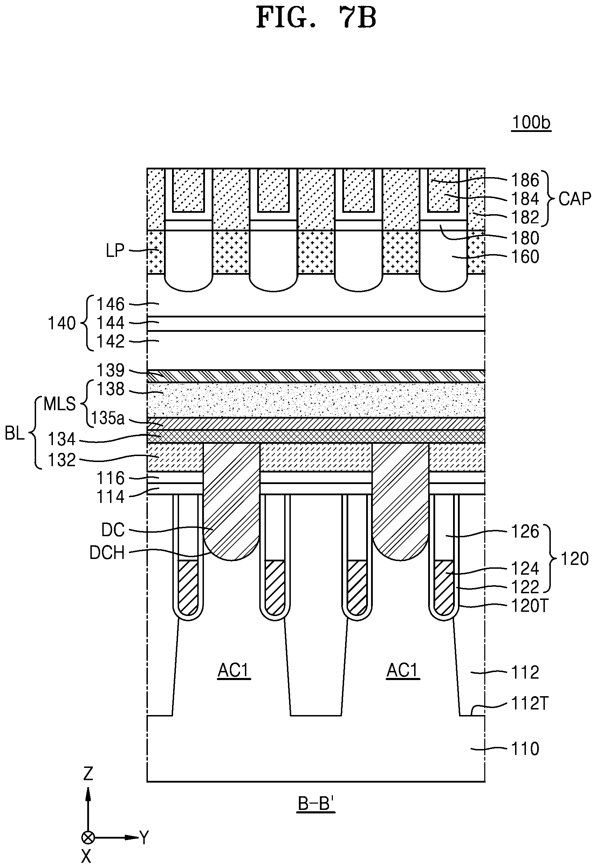

FIGS. 7A and 7B are cross-sectional views showing a semiconductor device 100b according to embodiments. It will be understood that the semiconductor device 100b of FIGS. 7A and 7B is not mutually exclusive with the semiconductor device 100 described with reference to FIGS. 1 to 5, and components having the same reference numerals may be considered to be the same component. Hereinafter, repeated descriptions of similar components will be omitted, and differences from the semiconductor device 100 of FIGS. 1 to 5 will be mainly described.

Referring to FIGS. 7A and 7B, the metal line stack MLS may include the first intermediate layer 135a and the conductive layer 138, and a capping layer 139 may be further disposed thereon. The thickness of the first intermediate layer 135a in the vertical direction (Z direction) may range from about 1.0 nm to about 5.0 nm. In one or more embodiments, the first intermediate layer 135a may include TaB. In this case, the content of B in the composition of TaB included in the first intermediate layer 135a may not exceed 30%.

In one or more embodiments, the thickness of the capping layer 139 in the vertical direction (Z direction) may range from about 1.0 nm to about 5.0 nm. For example, the capping layer 139 may be deposited to the same thickness as the first intermediate layer 135a. In one or more embodiments, the capping layer 139 may have the same composition as the first intermediate layer 135a. For example, the capping layer 139 may include a TaB alloy in which the content of B does not exceed 30%. In other embodiments, the capping layer 139 may include at least one of nano crystalline graphene (NCG), TiN, Ta, TaN, or an alloy thereof.

The semiconductor device 100b shown in FIGS. 7A and 7B may include the first intermediate layer 135a and the capping layer 139 including TaB on the top and bottom of the conductive layer 138, respectively to suppress grain growth of Ru included in the conductive layer 138.

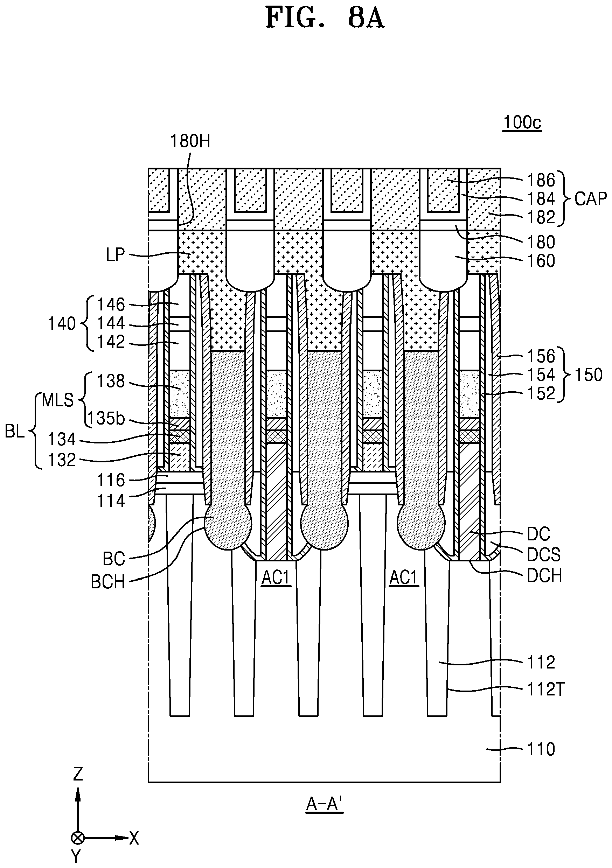

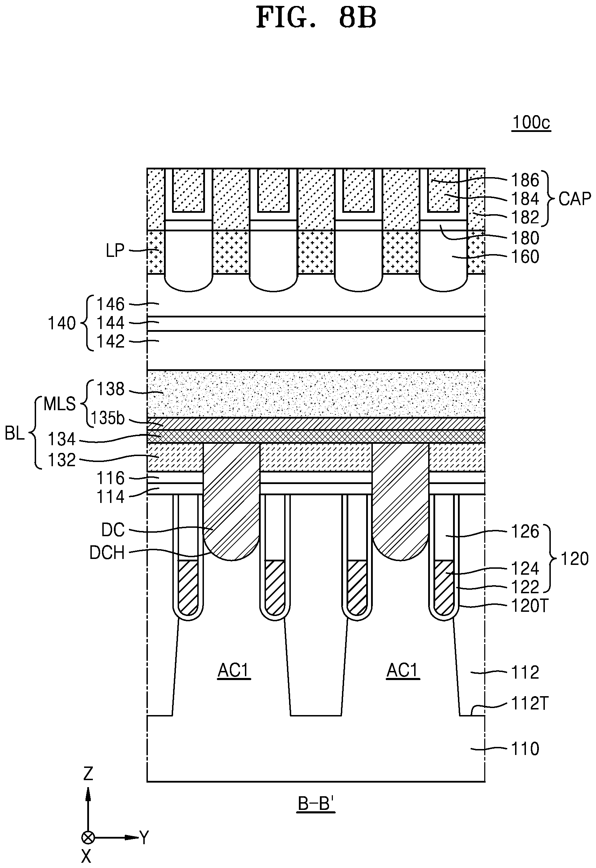

FIGS. 8A and 8B are cross-sectional views showing a semiconductor device 100c according to embodiments. It will be understood that the semiconductor device 100c of FIGS. 8A and 8B is not mutually exclusive with the semiconductor device 100 described with reference to FIGS. 1 to 5, and components having the same reference numerals may be considered to be the same component. Hereinafter, repeated descriptions of similar components will be omitted, and differences from the semiconductor device 100 of FIGS. 1 to 5 will be mainly described.

Referring to FIGS. 8A and 8B, the metal line stack MLS may include a second intermediate layer 135b and the conductive layer 138, and the thickness of the second intermediate layer 135b in the vertical direction (Z direction) may range from about 1.0 nm to about 5.0 nm. In one or more embodiments, the second intermediate layer 135b may include an RuTaB alloy. In this case, the content of B in the composition of the RuTaB alloy included in the second intermediate layer 135b may not exceed 30%. Compared to the semiconductor device 100 of FIGS. 1 to 5, the second intermediate layer 135b included in the semiconductor device 100c of FIGS. 8A to 8B may replace the barrier metal layer 136 and the adhesive layer 137 of the semiconductor device 100 of FIGS. 1 to 5. The capping layer 139 (refer to FIGS. 7A and 7B) may also be deposited to a thickness of about 1.0 nm to about 5.0 nm in the vertical direction (Z direction) on the metal line stack MLS.

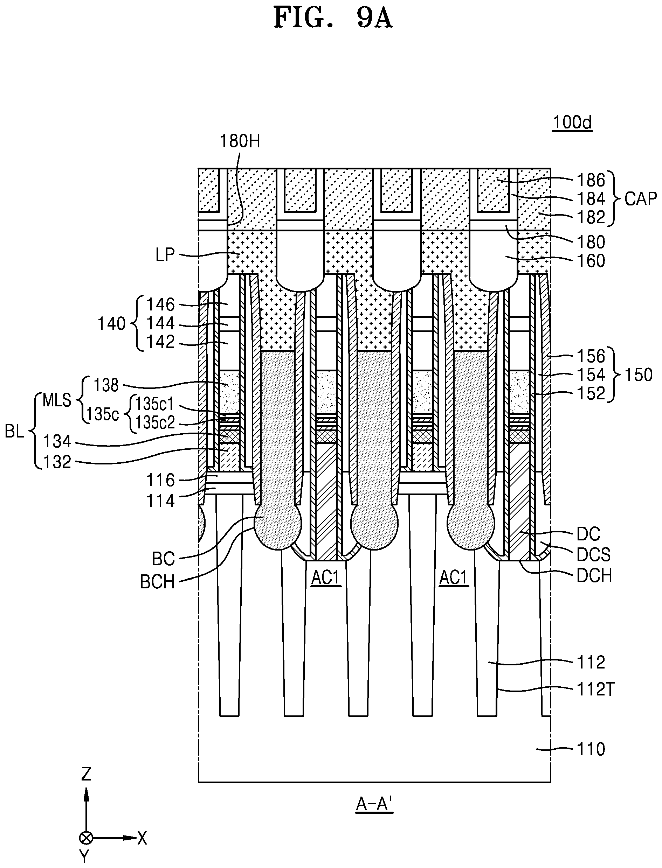

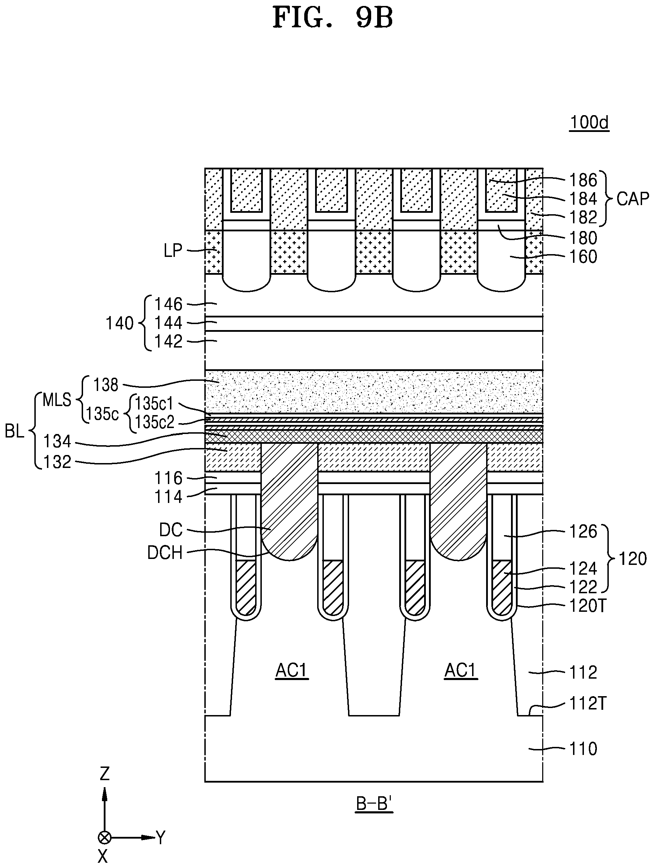

FIGS. 9A and 9B are cross-sectional views showing a semiconductor device 100d according to embodiments. It will be understood that the semiconductor device 100d of FIGS. 9A and 9B is not mutually exclusive with the semiconductor device 100 described with reference to FIGS. 1 to 5, and components having the same reference numerals may be considered to be the same component. Hereinafter, repeated descriptions of similar components will be omitted, and differences from the semiconductor device 100 of FIGS. 1 to 5 will be mainly described.

Referring to FIGS. 9A and 9B, the metal line stack MLS may include a third intermediate layer 135c and the conductive layer 138, and the thickness of the third intermediate layer 135c in the vertical direction (Z direction) may not exceed 20% of the thickness of the conductive layer 138. In one or more embodiments, the third intermediate layer 135c may have a layer-by-layer stack structure of a first superalloy layer 135c1 and a second superalloy layer 135c2. In one or more embodiments, each of the first superalloy layer 135c1 and the second superalloy layer 135c2 may have a thickness of about 0.05 nm to about 1.0 nm. A composition ratio of the entire third intermediate layer 135c may be adjusted by adjusting a thickness ratio of the first superalloy layer 135c1 and the second superalloy layer 135c2.

In one or more embodiments, the first superalloy layer 135c1 may include TaB, and the second superalloy layer 135c2 may include Ru. In this case, the content of B in the composition of TaB included in the first superalloy layer 135c1 may not exceed 30 %. Compared to the semiconductor device 100 of FIGS. 1 to 5, the third intermediate layer 135c included in the semiconductor device 100d of FIGS. 9A to 9B may replace the barrier metal layer 136 and the adhesive layer 137 of the semiconductor device 100 of FIGS. 1 to 5. The capping layer 139 (refer to FIGS. 7A and 7B) may also be deposited to a thickness of about 1.0 nm to about 5.0 nm in the vertical direction (Z direction) on the metal line stack MLS.

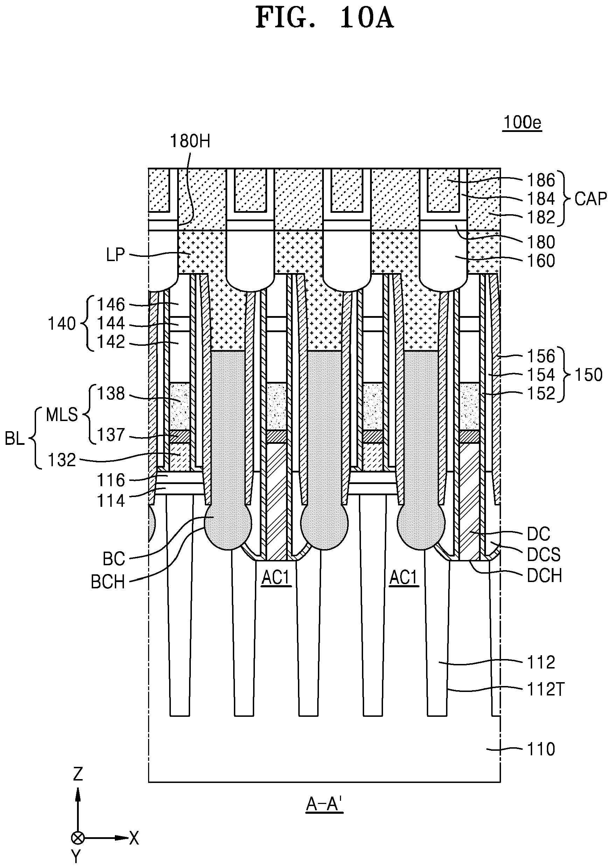

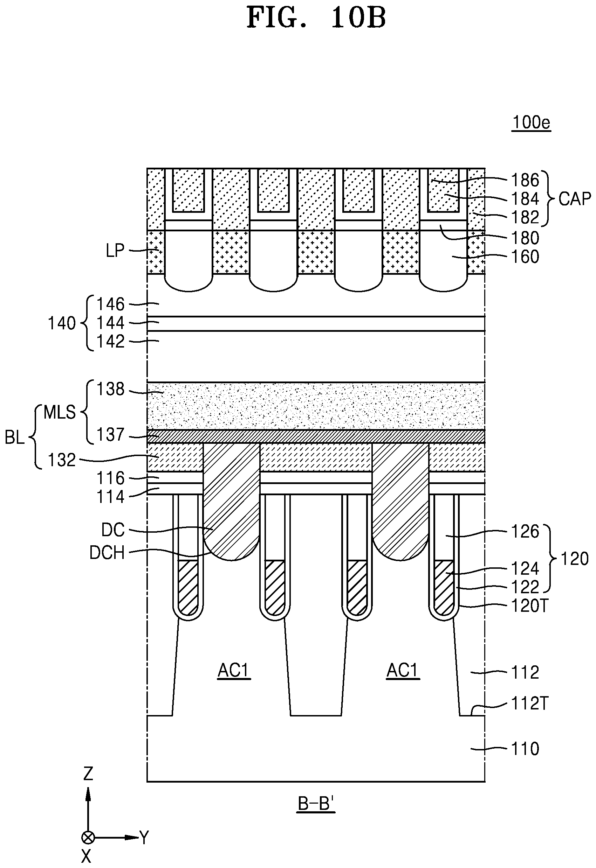

FIGS. 10A and 10B are cross-sectional views showing a semiconductor device 100e according to embodiments. It will be understood that the semiconductor device 100e of FIGS. 10A and 10B is not mutually exclusive with the semiconductor device 100 described with reference to FIGS. 1 to 5, and components having the same reference numerals may be considered to be the same component. Hereinafter, repeated descriptions of similar components will be omitted, and differences from the semiconductor device 100 of FIGS. 1 to 5 will be mainly described.

Referring to FIGS. 10A and 10B, the metal line stack MLS may include the adhesive layer 137 and the conductive layer 138, and the thickness of the adhesive layer 137 in the vertical direction (Z direction) may range from about 1.0 nm to about 5.0 nm. In one or more embodiments, the adhesive layer 137 may include TaB. In this case, the content of B in the composition of TaB included in the adhesive layer 137 may not exceed 30 %. Compared to the bit line contact DC of the semiconductor device 100 shown in FIGS. 1 to 5 including polysilicon, the bit line contact DC included in the semiconductor device 100e of FIGS. 10A to 10B may include any single metal material selected from W, Ti, TiN, Mo, Ru, Rh, Ir, Cu, Co, and W, or an alloy material selected from RuAl, NiAl, NbB₂, MoB₂, and MoW. As the bit line contact DC includes a metal material, the adhesive layer 137 may be disposed on the lower conductive layer 132 without the metal silicide film 134 (refer to FIGS. 1 to 5) and the barrier metal layer 136 (refer to FIGS. 1 to 5).

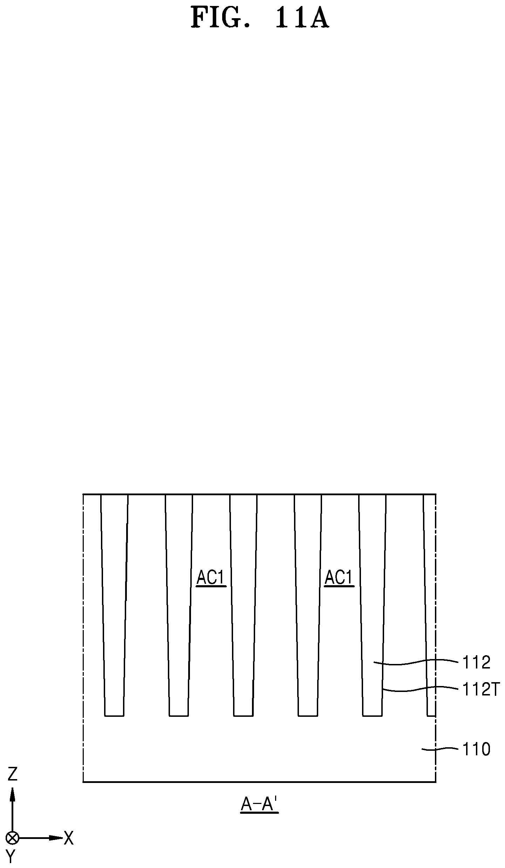

FIGS. 11A, 11B, 12A, 12B, 13A, 13B, 14A, 14B, 15A, 15B, 16A, 16B, 17A, 17B, 18A, 18B, 19A, 19B, 20A, and 20B are cross-sectional views showing a method of manufacturing the semiconductor device 100, according to one or more embodiments. In detail, FIGS. 11A, 12A, 13A, 14A, 15A, 16A, 17A, 18A, 19A, and 20A are cross-sectional views corresponding to a cross section A-A' of FIG. 2, and FIGS. 11B, 12B, 13B, 14B, 15B, 16B, 17B, 18B, 19B, and 20B are cross-sectional views corresponding to a cross section B-B' of FIG. 2.

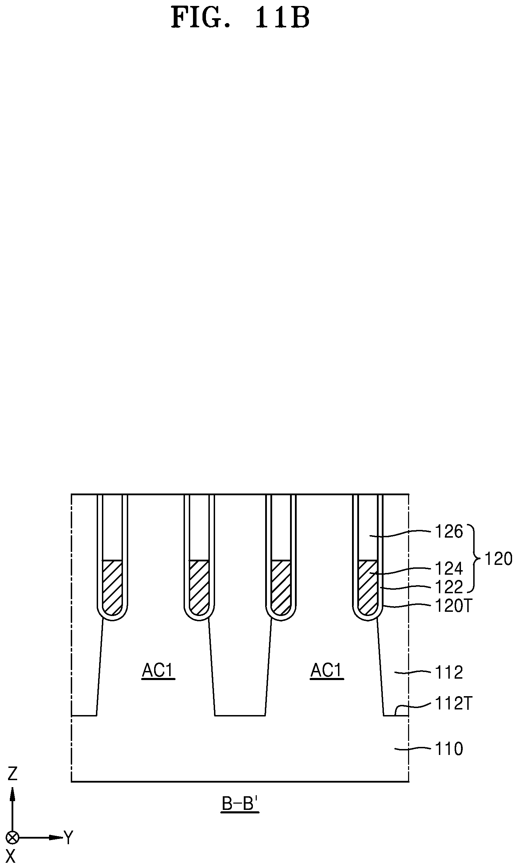

Referring to FIGS. 11A and 11B, a plurality of device separation trenches 112T may be formed in the substrate 110.

Then, the first device separation film 112 may be formed to fill the plurality of device separation trenches 112T. The plurality of first active areas AC1 may be defined in the substrate 110 by forming the first device separation film 112. From a plan view, the plurality of first active areas AC1 may extend in the first diagonal direction (D1 direction) (refer to FIG. 2) inclined at a certain angle with the first horizontal direction (X direction) and the second horizontal direction (Y direction).

In one or more embodiments, the first device separation film 112 may be formed using silicon oxide, silicon nitride, silicon oxynitride, or a combination thereof. In some examples, the first device separation film 112 may be formed in a double-layer structure of a silicon oxide layer and a silicon nitride layer, but is not limited thereto.

A mask pattern may be formed on the substrate 110 and a word line trench 120T may be formed by removing a portion of the substrate 110 by using the mask pattern as an etch mask. For example, a mask pattern for forming the word line trench 120T may be formed using a double patterning technology (DPT) or a quadruple patterning technology (QPT), but the disclosure is not limited thereto.

Then, the gate dielectric layer 122, the gate electrode 124, and the word line capping layer 126 may be sequentially formed in the word line trench 120T.

For example, the gate dielectric layer 122 may be conformally located on an inner wall of the word line trench 120T. The gate electrode 124 may be formed by filling the word line trench 120T with a conductive layer and then etching back an upper portion of the conductive layer to expose a portion of an upper side of the word line trench 120T again.

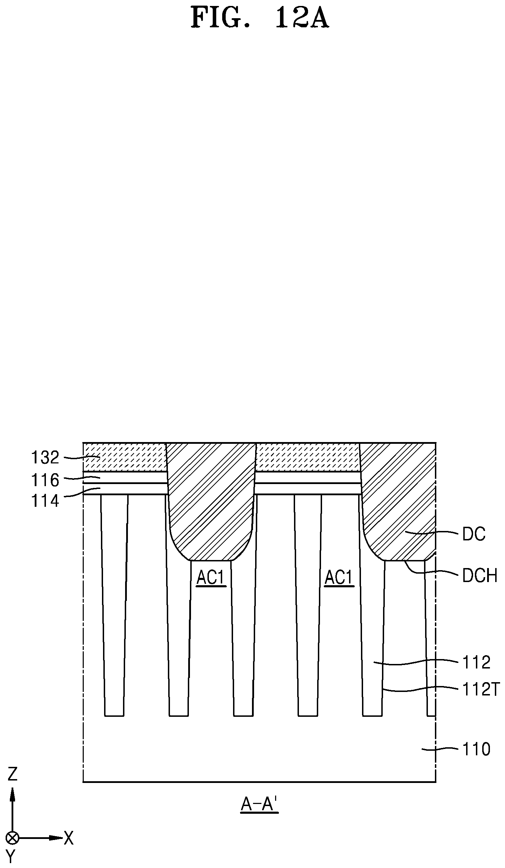

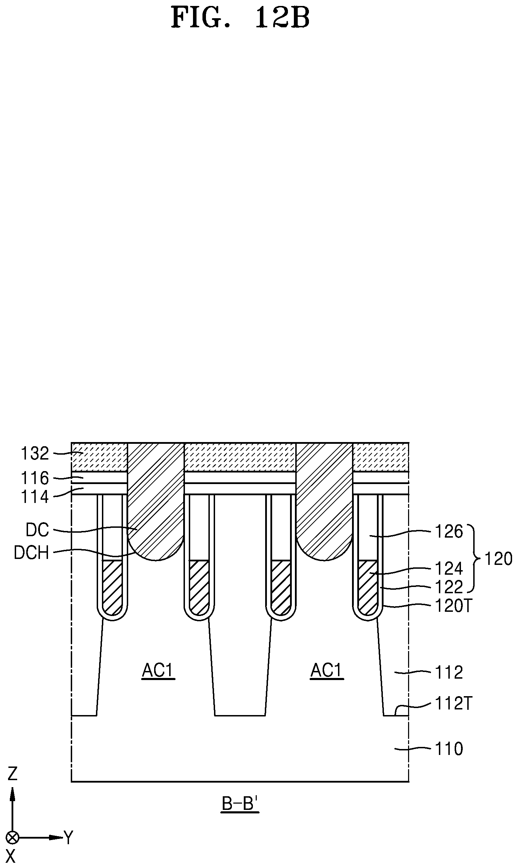

Referring to FIGS. 12A and 12B, the first buffer insulating layer 114 and the second buffer insulating layer 116 may be formed on the first active area AC1 and the first device separation film 112. Then, the lower conductive layer 132 may be formed on the first and second buffer insulating layers 114 and 116. The bit line contact hole DCH may be formed by removing a portion of the lower conductive layer 132, the first and second buffer insulating layers 114 and 116, and the substrate 110. Then, the bit line contact DC including doped polysilicon may be formed inside the bit line contact hole DCH.

In one or more embodiments, the lower conductive layer 132 may include Si, Ge, W, WN, Co, Ni, Al, Mo, Ru, Ti, TiN, Ta, TaN, Cu, or a combination thereof.

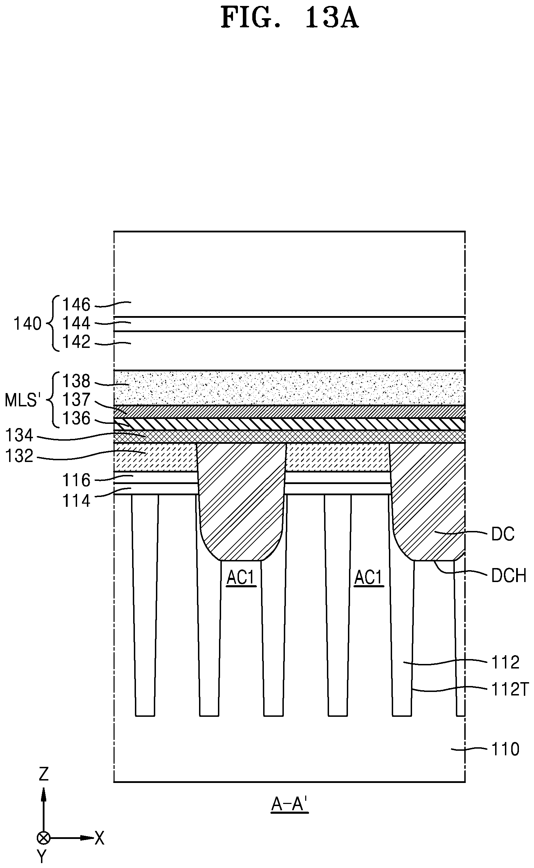

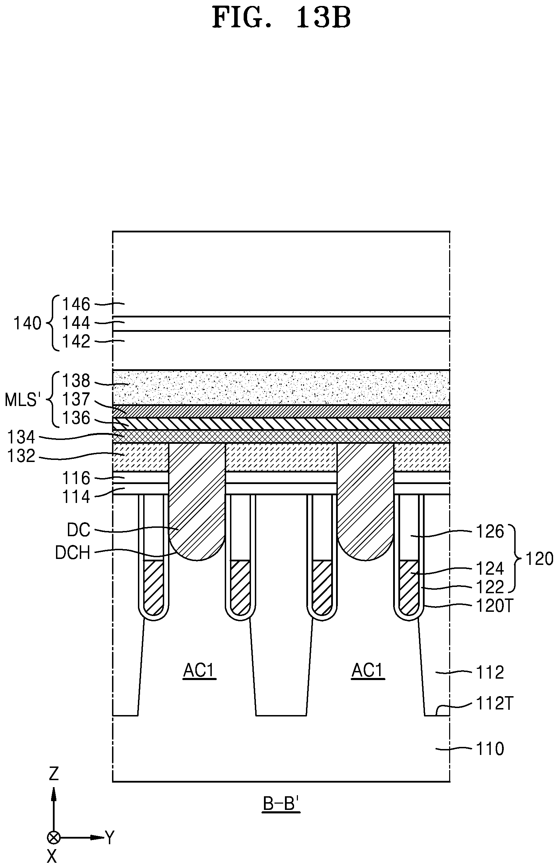

Referring to FIGS. 13A and 13B, the metal silicide film 134 may be formed on the bit line contact DC and the lower conductive layer 132. The metal silicide film 134 may be formed using at least one of cobalt silicide, nickel silicide, and tungsten silicide. In one or more embodiments, the metal silicide film 134 may be deposited to a thickness of about 1.0 nm to about 3.0 nm in the vertical direction (Z direction).

Then, the barrier metal layer 136, the adhesive layer 137, and the conductive layer 138 may be sequentially formed on the metal silicide film 134.

In one or more embodiments, the barrier metal layer 136 may include any one of TiN, TaN, WN, TiSiN, or an alloy thereof. In one or more embodiments, the adhesive layer 137 may include any one of TEOS, SiN, TiN, TaB, Ta, TaN, or an alloy thereof. In one or more embodiments, the adhesive layer 137 may include TaB. In this case, the content of B in the composition of TaB included in the adhesive layer 137 may not exceed 30 %. In one or more embodiments, the conductive layer 138 may include ruthenium (Ru). In one or more embodiments, the conductive layer 138 may have a single composition including any one material selected from Rh, Ir, Mo, Cu, Co, and W and include an alloy material that is any one of RuAl, NiAl, NbB₂, MoB₂, MoW, or an alloy thereof.

In one or more embodiments, the sum of the thickness of the barrier metal layer 136 and the thickness of the adhesive layer 137 may range from about 1.0 nm to about 5.0 nm. In one or more embodiments, the thickness of the adhesive layer 137 may not exceed 20 % of the thickness of the conductive layer 138.

Here, the stacked structure of the barrier metal layer 136, the adhesive layer 137, and the conductive layer 138 may be referred to as a preliminary metal line stack MLS'. Then, the bit line capping layer 140 may be formed on the preliminary metal line stack MLS'. Each of the bit line capping layers 140 may include the first capping layer 142, the second capping layer 144, and the third capping layer 146 that are sequentially disposed on an upper surface of each of the preliminary metal line stack MLS'. The first capping layer 142, the second capping layer 144, and the third capping layer 146 may be formed using at least one of silicon nitride, silicon oxide, and silicon oxynitride.

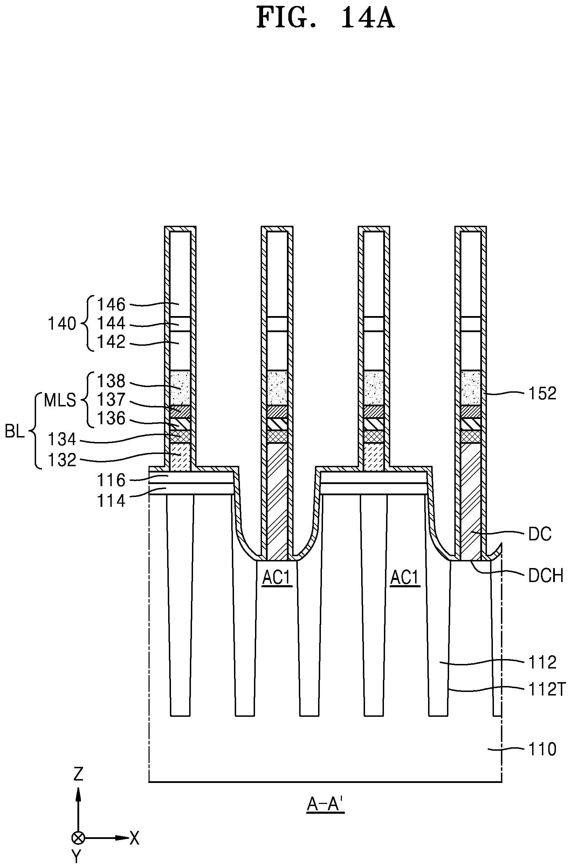

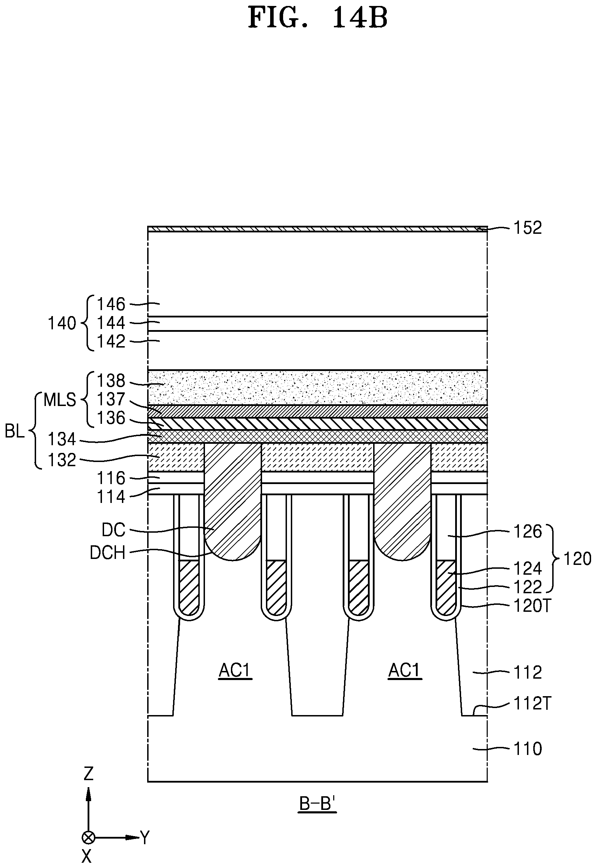

Referring to FIGS. 14A and 14B, the plurality of bit lines BL may be formed by patterning the preliminary metal line stack MLS', the metal silicide film 134, and the lower conductive layer 132 by using the bit line capping layer 140 as an etch mask.

In the patterning process to form the plurality of bit lines BL, a portion of the bit line contact DC located in the bit line contact hole DCH may also be removed. Accordingly, as shown in FIG. 14A, the sidewall of the bit line contact DC may be formed to be aligned with the sidewall of the bit line BL, and the inner walls of the bit line contact hole DCH may be exposed through both sides of the bit line contact DC again.

Then, the first spacer layer 152 may be formed on sidewalls of the bit line BL, the bit line capping layer 140, and the bit line contact DC. The first spacer layer 152 may also be conformally located on the inner wall of the bit line contact hole DCH. In one or more embodiments, the first spacer layer 152 may be formed using silicon nitride.

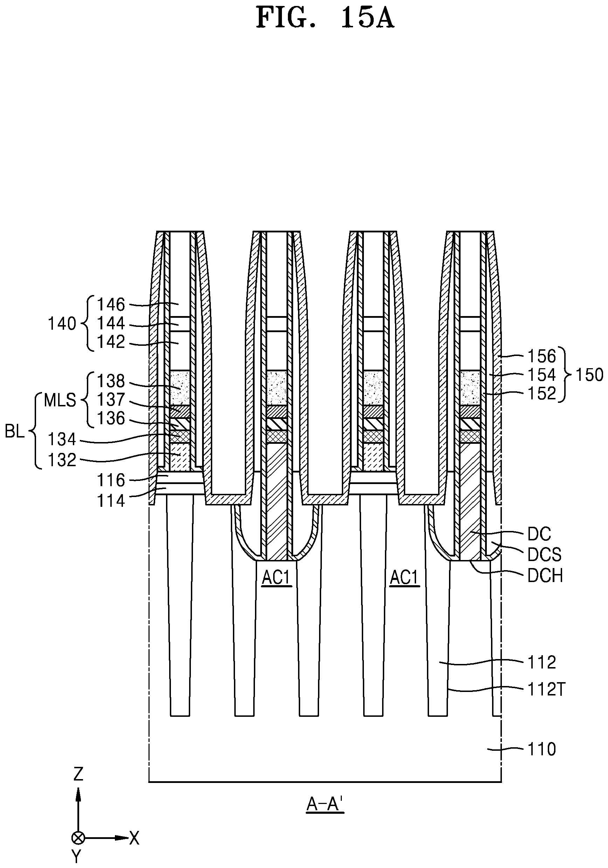

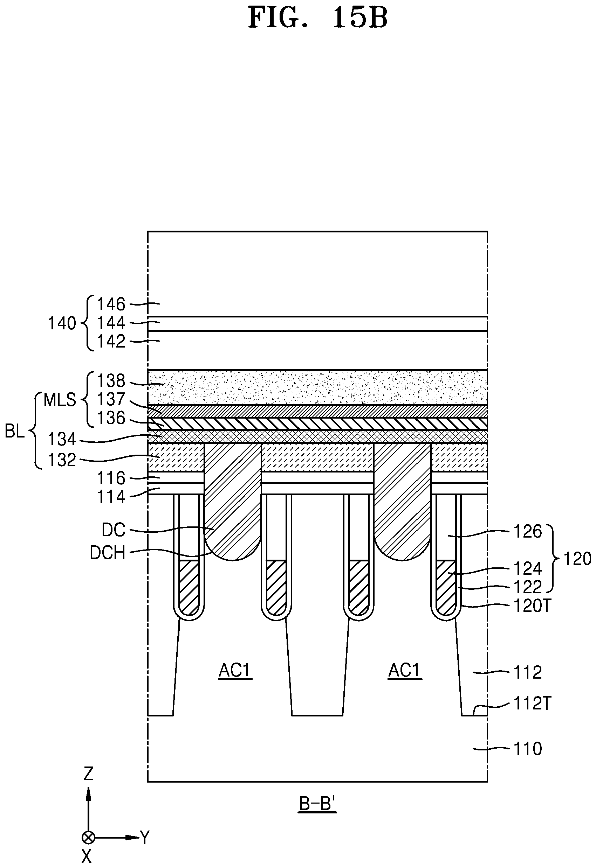

Referring to FIGS. 15A and 15B, the bit line contact spacer DCS may be formed by filling the remaining portion of the bit line contact hole DCH on the first spacer layer 152. For example, the bit line contact spacer DCS may be formed using silicon nitride or silicon oxide.

Then, the second spacer layer 154 may be formed on the sidewalls of the bit line BL and the bit line capping layer 140. In one or more embodiments, the second spacer layer 154 may be formed using silicon oxide.

Then, an anisotropic etching process may be performed on the second spacer layer 154, and portions of the first and second buffer insulating layers 114 and 116 located between the bit lines BL may be removed to expose the upper surface of the substrate 110.

Then, the third spacer layer 156 may be conformally formed on upper surfaces of the second spacer layer 154 and the substrate 110. In one or more embodiments, the third spacer layer 156 may be formed using silicon nitride.

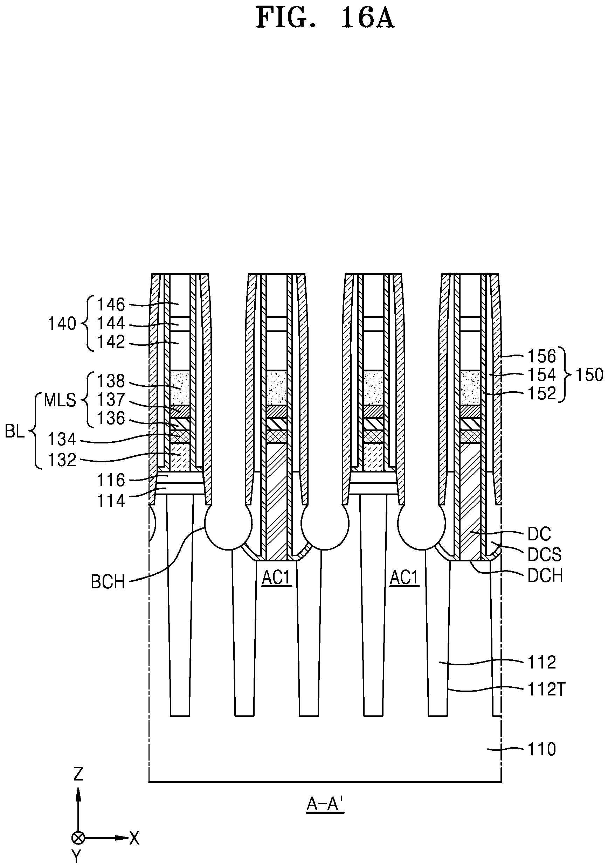

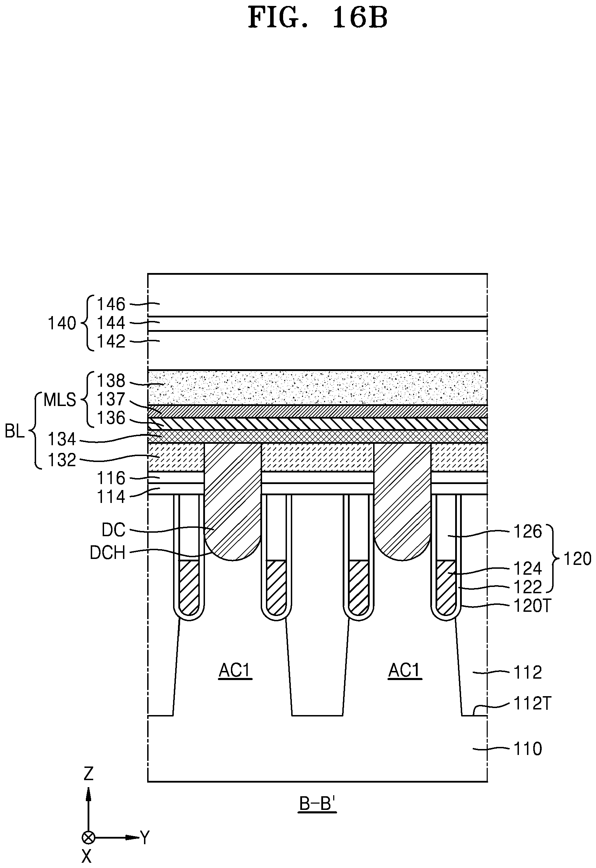

Referring to FIGS. 16A and 16B, the upper side of the substrate 110 exposed in the space between the plurality of bit lines BL may be further removed to form the buried contact hole BCH. In one or more embodiments, a process of forming the buried contact hole BCH may include a wet etching process, a dry etching process, or a combination thereof.

In an etching process to form the buried contact hole BCH, a portion of the upper portion of the bit line capping layer 140 may also be removed, thereby lowering the upper surface level of the bit line capping layer 140.

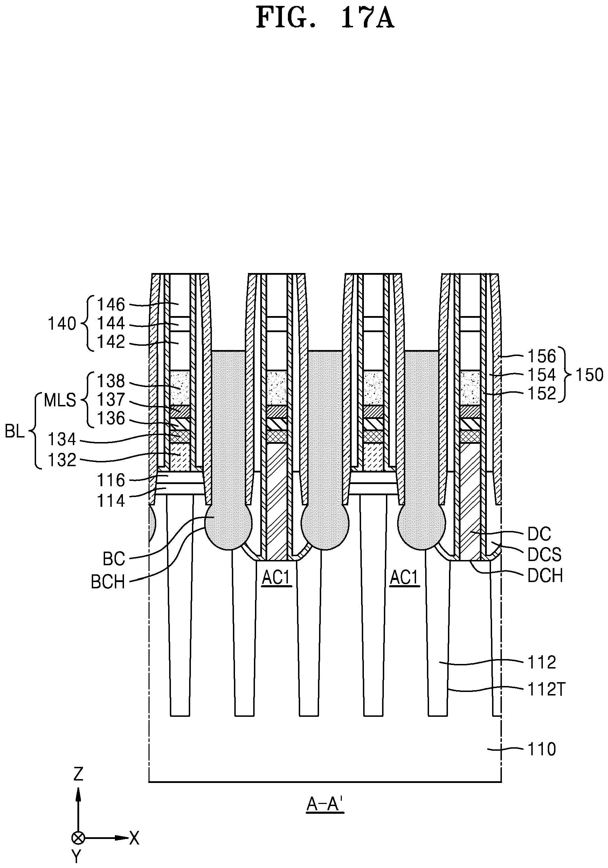

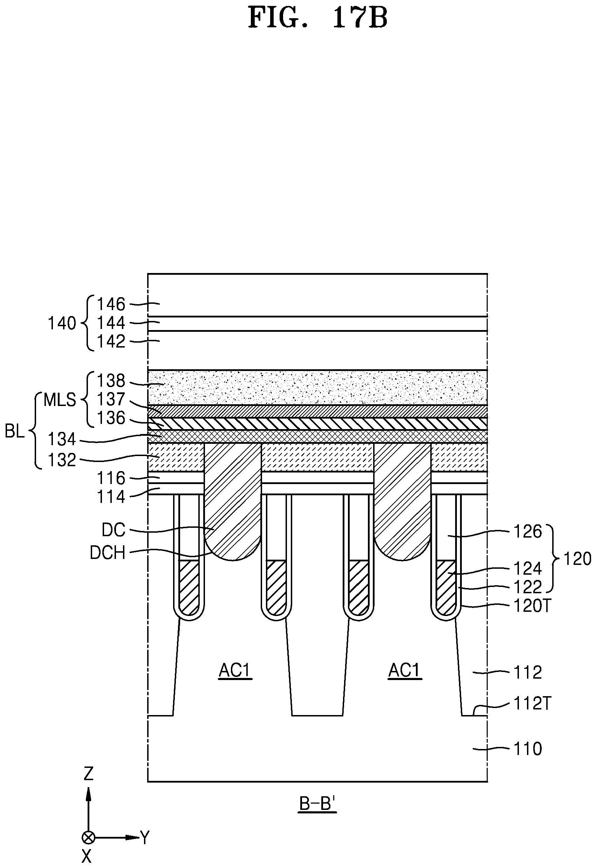

Referring to FIGS. 17A and 17B, the buried contact BC may be formed to fill the inside of the buried contact hole BCH. In one or more embodiments, the buried contact BC may be formed using doped polysilicon.

In one or more embodiments, the buried contact hole BCH may be formed to have a line-type planar shape located between adjacent bit lines BL, and then, a preliminary contact layer having a line-type planar shape may be formed inside the buried contact hole BCH and may be patterned to form the buried contact BC. Then, an insulating fence may be formed using an insulating material in a space between the buried contacts BC (for example, a space from which a portion of the preliminary contact layer is removed).

In other embodiments, before the buried contact hole BCH is formed, a plurality of insulating fences may be formed using an insulating material at an intersection of the word line trench 120T with a space between two adjacent bit lines BL, portions of the substrate 110 between the plurality of bit lines BL and between the plurality of insulating fences may be removed to form the buried contact hole BCH, and then the buried contact BC may be formed in the buried contact hole BCH.

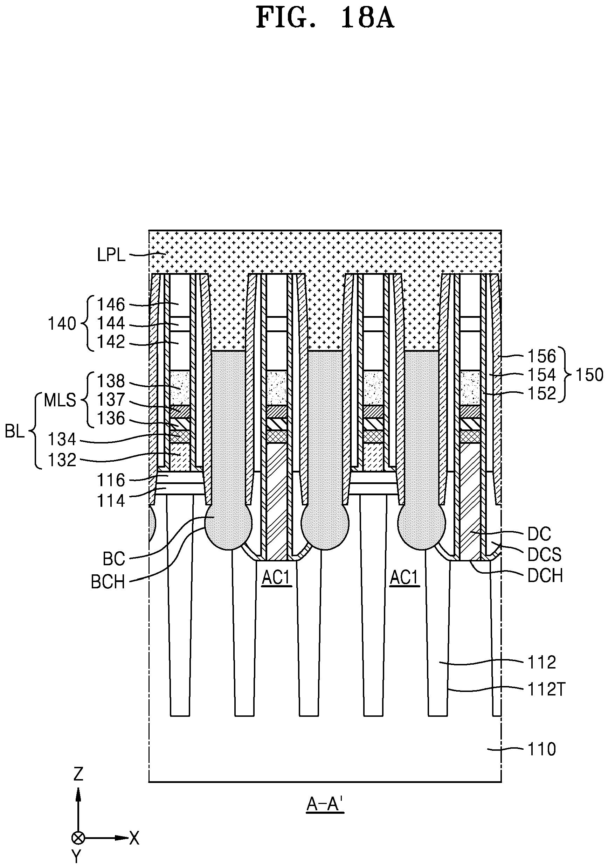

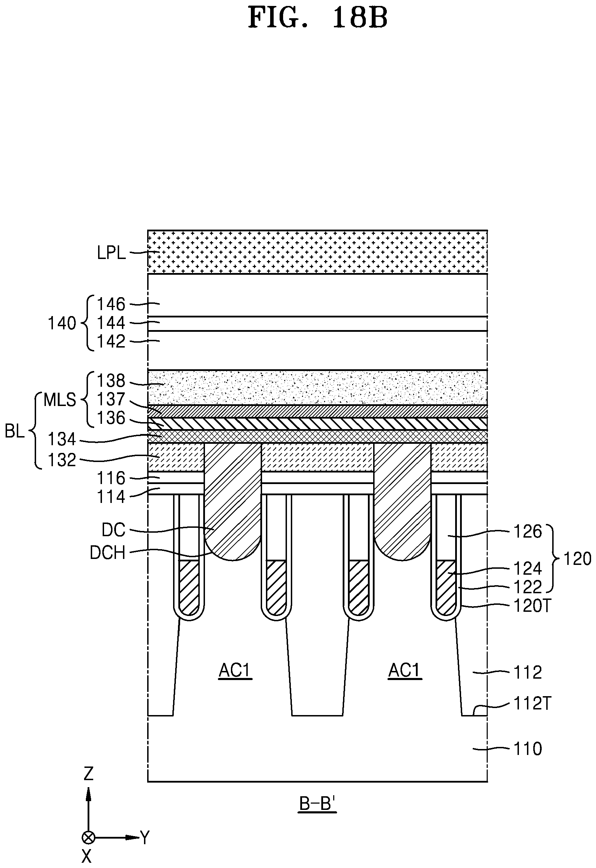

Referring to FIGS. 18A and 18B, a landing pad conductive layer LPL may be formed on the upper surfaces of the plurality of buried contacts BC. The landing pad conductive layer LPL may be formed to have a sufficient thickness to be in contact with the buried contact BC and to cover the upper surface of the bit line capping layer 140.

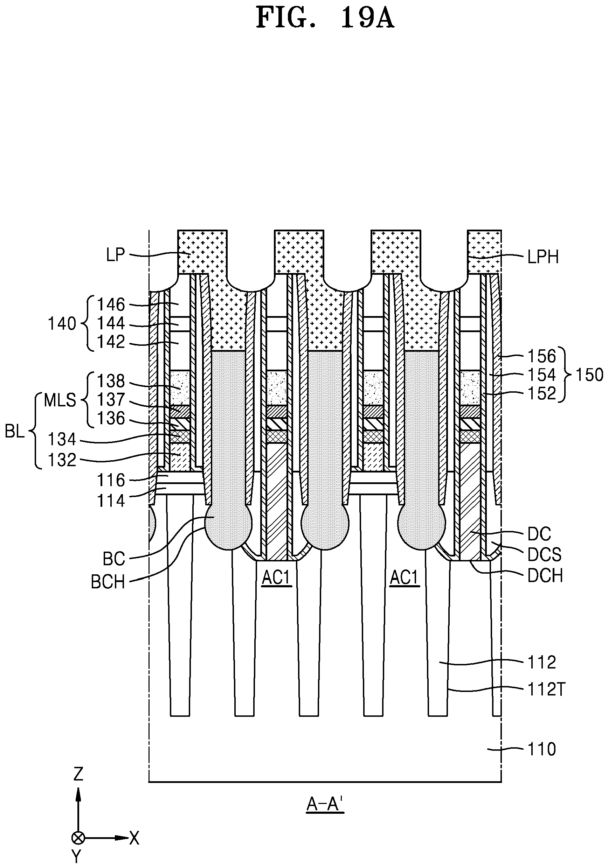

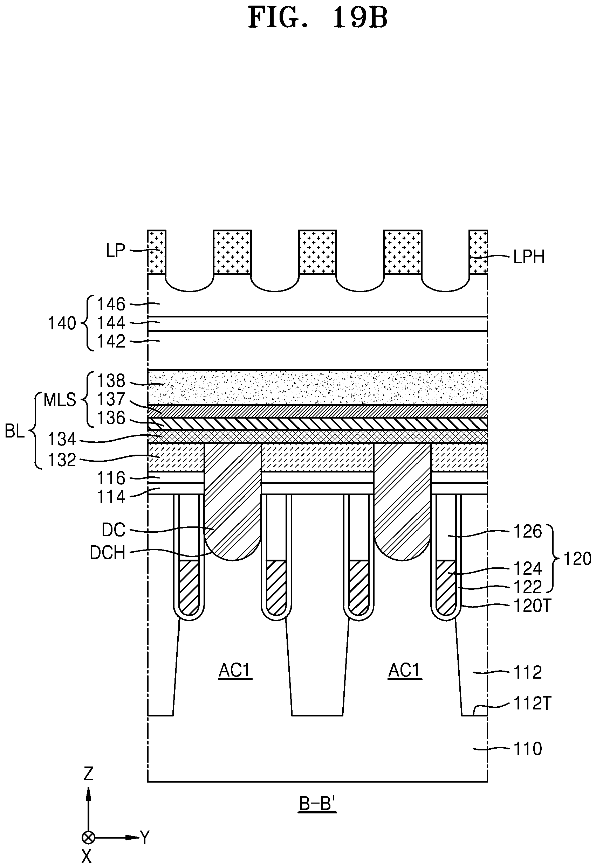

Referring to FIGS. 19A and 19B, a mask pattern may be formed on the landing pad conductive layer LPL and the landing pad conductive layer LPL may be patterned using the mask pattern as an etch mask to form a landing pad opening LPH. The plurality of landing pads LP disposed on each of the plurality of buried contacts BC may be formed by the landing pad opening LPH.

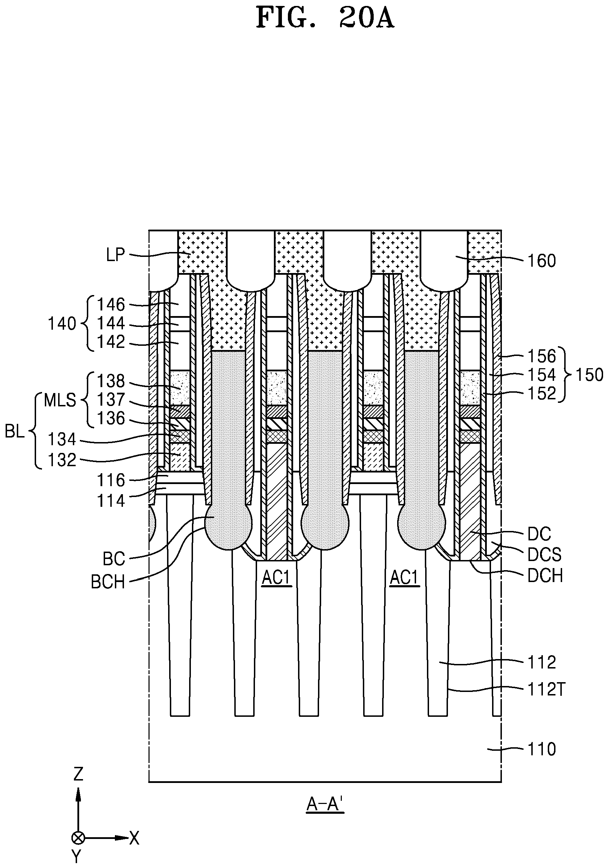

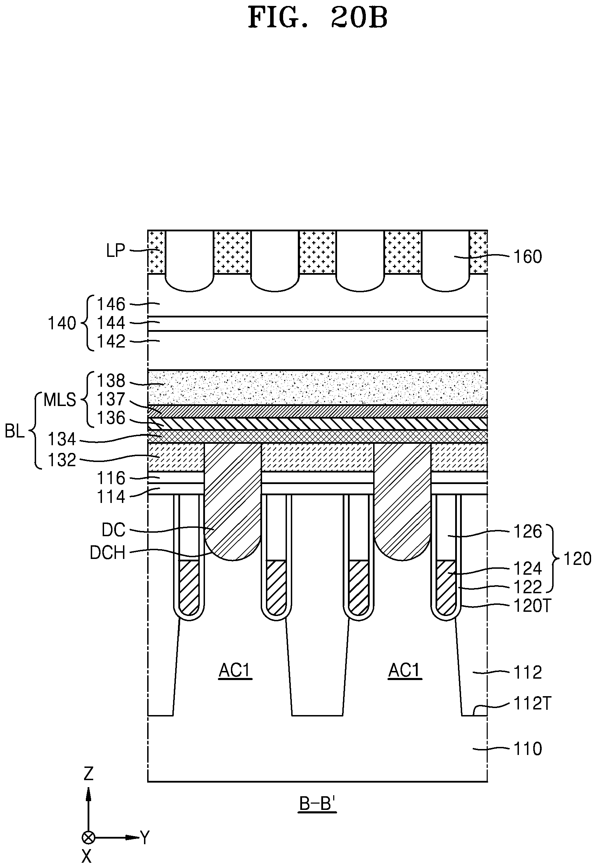

Referring to FIGS. 20A and 20B, the insulating pattern 160 may be formed using an insulating material within the landing pad opening LPH. The insulating pattern 160 may be arranged to cover the sidewalls of the plurality of landing pads LP.

Referring back to FIGS. 3 and 4, the plurality of lower electrodes 182 connected to the landing pad LP may be formed, and the capacitor dielectric layer 184 and the upper electrode 186 may be sequentially formed on the sidewalls of the plurality of lower electrodes 182. The semiconductor device 100 shown in FIGS. 1 to 5 may be completed by performing the above-described method.

While the disclosure has been particularly shown and described with reference to embodiments thereof, it will be understood that various changes in form and details may be made therein without departing from the scope of the following claims.

## Claims

1. A semiconductor device comprising:
a substrate (110) comprising a first active area (AC1) defined by a first device separation film (112);
a bit line contact (DC) in the first active area (AC1); and
a bit line (BL) extending in a first direction on the substrate (110),
wherein the bit line (BL) comprises:
a lower conductive layer (132) on the substrate (110) and surrounding at least a portion of a sidewall of the bit line contact (DC);
a metal silicide film (134) on the lower conductive layer (132) and the bit line contact (DC); and
an intermediate layer (135a; 135b; 135c; 137) and a conductive layer (138) that are sequentially arranged on the metal silicide film (134) in a vertical direction (Z) perpendicular to the substrate (110), and
wherein the intermediate layer (135a; 135b; 135c; 137) comprises a tantalum, Ta, alloy.

2. The semiconductor device of claim 1,
wherein a thickness of the intermediate layer (135a; 135b; 135c; 137) in the vertical direction (Z) does not exceed 20% of a thickness of the conductive layer (138) in the vertical direction (Z).

3. The semiconductor device of claim 1 or 2, wherein the tantalum, Ta, alloy of the intermediate layer (135a; 135b; 135c; 137) comprises tantalum boron, TaB, or RuTaB, wherein a boron, B, content of the tantalum boron, TaB, or the RuTaB is less than or equal to 30%.

4. The semiconductor device of claim 1 or 2,
wherein the intermediate layer (135c) comprises a plurality of first superalloy layers (135c1) and a plurality of second superalloy layers (135c2) that are alternately stacked, and
wherein the plurality of first superalloy layers (135c1) comprise tantalum boron, TaB, and the plurality of second superalloy layers (135c2) comprise ruthenium, Ru.

5. The semiconductor device of claim 4,
wherein a thickness of a layer of each of the plurality of first superalloy layers (135c1) and the plurality of second superalloy layers (135c2) is in a range of about 0.05 nm to about 1.0 nm, and
wherein the plurality of first superalloy layers (135c1) comprise tantalum boron, TaB, comprising a boron, B, content less than or equal to 30%.

6. The semiconductor device of any one of claims 1 to 5, further comprising a barrier metal layer (136) between the intermediate layer (137) and the metal silicide film (134).

7. The semiconductor device of claim 6, wherein a sum of a thickness of the barrier metal layer (136) and a thickness of the intermediate layer (137) in the vertical direction (Z) is in a range of about 1.0 nm to about 5.0 nm.

8. The semiconductor device of any one of claims 1 to 7, wherein the conductive layer (138) comprises ruthenium, Ru.

9. The semiconductor device of any one of claims 1 to 8, wherein a thickness of the metal silicide film (134) in the vertical direction (Z) is in a range of about 1.0 nm to about 3.0nm.

10. The semiconductor device of any one of claims 1 to 9, further comprising a capping layer (139) on the conductive layer (138),
wherein the capping layer (139) comprises a tantalum, Ta, alloy.

11. The semiconductor device of claim 10, wherein the capping layer (139) comprises tantalum boron, TaB, wherein a boron, B, content of the tantalum boron, TaB, of the capping layer (139) is less than or equal to 30%, and a thickness of the capping layer (139) in the vertical direction (Z) is in a range of about 1.0 nm to about 5.0 nm.

12. The semiconductor device of any one of claims 1 to 11,
wherein the substrate (110) further comprises a second active area (AC2) defined by a second device separation film (112P),
wherein the semiconductor device (100) further comprises a peripheral circuit gate stack (PGS) in the second active area (AC2), and
wherein the peripheral circuit gate stack (PGS) comprises a peripheral lower conductive layer (132P), a peripheral barrier metal layer (136P), a peripheral adhesive layer (137P), and a peripheral conductive layer (138P), wherein the peripheral barrier metal layer (136P), the peripheral adhesive layer (137P), and the peripheral conductive layer (138P) are sequentially arranged in the vertical direction (Z) on the peripheral lower conductive layer (132P).

13. A semiconductor device comprising:
a substrate (110) comprising a first active area (AC1) and a second active area (AC2);
a bit line contact (DC) in the first active area (AC1);
a peripheral circuit gate stack (PGS) in the second active area (AC2); and
a bit line (BL) extending in a first direction on the substrate (110),
wherein the bit line (BL) comprises a lower conductive layer (132) on the substrate (110) and surrounding at least a portion of a sidewall of the bit line contact (DC), and a metal line stack (MLS) on the lower conductive layer (132), and
wherein the metal line stack (MLS) comprises a barrier metal layer (136), an adhesive layer (137) on the barrier metal layer (136), and a conductive layer (138) on the adhesive layer (137).

14. The semiconductor device of claim 13, further comprising a capping layer (139) on the conductive layer (138),
wherein the capping layer (139) comprises tantalum boron, TaB, and comprises a thickness in a range of about 1.0 nm to about 5.0 nm.

15. The semiconductor device of claim 13 or 14,
wherein a sum of a thickness of the barrier metal layer (136) and a thickness of the adhesive layer (137) is in a range of about 1.0 nm to about 5.0 nm, and
wherein the thickness of the adhesive layer (137) is less than or equal to 20% of the thickness of the conductive layer (138).
